# EUROPÄISCHE PATENTSCHRIFT

(11) **EP 2 809 005 B1**
(45) Veröffentlichungstag und Bekanntmachung des Hinweises auf die Patenterteilung: **10.03.2021**
(21) Anmeldenummer: 14002538.8
(22) Anmeldetag: 05.09.2011
(51) Int. Cl.: H03K 17/955, B60R 19/48

(54) **Kapazitiver Abstandssensor**
Capacitive distance sensor
Capteur de proximité capacitif

(30) Priorität: 10.09.2010 DE 102010045008
(43) Veröffentlichungstag der Anmeldung: 03.12.2014
(62) Teilanmeldung aus: 11761502.1
(73) Patentinhaber: Brose Fahrzeugteile SE & Co. Kommanditgesellschaft, Bamberg, 96052 Bamberg (DE)
(72) Erfinder: Würstlein, Holger, DE-97475 Zeil am Main (DE); Kuhnen, Thorsten, DE-96123 Litzendorf (DE)
(74) Vertreter: FDST Patentanwälte

(56) Entgegenhaltungen:
- WO-A2-2009/048910
- GB-A- 2 255 641
- US-A- 5 326 133
- US-A1- 2009 295 410

## Beschreibung

Die Erfindung betrifft einen kapazitiven Abstandssensor mit einem langgestreckten Sensorelement, insbesondere für die Anwendung in der Automobilindustrie. Weiterhin betrifft die Erfindung ein Verfahren zur Herstellung eines solchen Sensorelements.

In der Automobilindustrie finden solche Sensoren insbesondere Verwendung zur Detektion eines sich an ein Fahrzeug oder Fahrzeugteil annäherndes Objekts, zum Beispiel als Teil einer Einparkhilfe oder als Teil eines Einklemmschutzes für elektrisch verstellbare Fenster oder Türen. Ein weiteres Anwendungsgebiet derartiger kapazitiver Abstandssensoren liegt in der Raumfahrt oder in der Verwendung bei Industrieanlagen.

Aus der US005166679A ist ein kapazitiver Abstandssensor mit einem eine Sensorfläche umfassenden Sensorelement bekannt, das an einem zu schützenden Element angebracht ist. Die Sensorfläche ist im Wesentlichen eine plane, ausgedehnte, dünne und elektrisch leitende Fläche und bildet eine Elektrode eines Kondensators. Als Gegenelektrode des Kondensators dient ein in den von dem Sensor zu überwachenden Bereich eindringendes Objekt. Bei einer Annäherung des Objekts an das Sensorelement ändert sich die Kapazität des zwischen der Sensorfläche und der Gegenelektrode gebildeten Kondensators. Die Kapazitätsänderung wird direkt und/oder indirekt mittels einer Elektronik gemessen. Mittels der Messdaten wird der Abstand des Objekts zu dem Sensorelement bestimmt.

In der DE 602 05 520 T2 wird ein weiterer kapazitiver Abstandssensor mit einem langgestreckten Sensorelement offenbart. Das Sensorelement wird hier an ein Karosserieteil eines Kraftfahrzeugs geklebt.

Aus WO 2009/048910 A2 ist ein weiterer kapazitiver Abstandssensor mit einem Sensorelement bekannt. Das Sensorelement umfasst eine elektrisch leitende, langgestreckte, flache Sensorfläche, die zumindest optional von einem elektrisch nicht-leitenden Isolierkörper vollständig umschlossen ist. Der bekannte Abstandssensor kann mittels vorgeformter Befestigungslöcher an einem Fahrzeugstoßfänger befestigt werden. Die Befestigungslöcher sind dabei mit Abstand zu dem Abstandssensor und dessen Sensorfläche in einem Träger eingebracht sind, an dem seinerseits der Sensor befestigt ist.

Aus GB 2 255 641 A ist des Weiteren ein Abstandssensor mit einem Sensorelement bekannt, das eine elektrisch leitende, langgestreckte, flache Sensorfläche umfasst. Die Sensorfläche ist mit zwei Löchern versehen, durch die hindurch der Sensor mittels Bolzen an einer Fahrzeugkarosserie befestigt wird. Der bekannte Sensor ist an einem Fahrzeugstoßfänger aus Gussharz angeordnet.

Dokument US 2009/0295410 A1 offenbart eine Sensorelektrode eines kapazitiven Sensors, bei der die Sensorfläche vollständig von einem Isolierkörper umgeben ist und in denselben eingeklemmt wird.

Der Erfindung liegt die Aufgabe zugrunde, einen kapazitiven Abstandssensor mit einem langgestreckten Sensorelement anzugeben, das an einem Objekt einfach und sicher befestigbar ist, und das unanfällig gegen Korrosion und Verschmutzung ist. Weiterhin liegt der Erfindung die Aufgabe zugrunde, ein besonders geeignetes Verfahren zur Herstellung eines solchen Sensorelements anzugeben.

Bezüglich des Abstandssensors wird diese Aufgabe erfindungsgemäß gelöst durch die Merkmale des Anspruchs 1. Bezüglich des Verfahrens zur Herstellung des Sensorelements wird die Aufgabe gelöst durch die Merkmale des Anspruchs 7. Vorteilhafte Weiterbildungen und Ausgestaltungen der Erfindung sind Gegenstand der Unteransprüche Erfindungsgemäß umfasst der kapazitive Abstandssensor ein langgestrecktes Sensorelement, das eine elektrisch leitende, langgestreckte, flache Sensorfläche enthält. In die, insbesondere streifenförmige, Sensorfläche ist eine Anzahl von Löchern eingebracht. Beispielsweise dienen die Löcher dazu, ein Befestigungsmittel wie eine Schraube oder einen Clip aufzunehmen, mittels dessen das Sensorelement an einem Objekt, wie der Karosserie eines Kraftfahrzeugs, befestigt werden kann. Eine solche Befestigung ermöglicht eine vergleichsweise schnelle Montage des Sensorelements. Zum Schutz der Sensorfläche vor mechanischer oder chemischer Beschädigung, wie zum Bespiel Witterungseinflüssen bei einer Montage des Sensorelements im Außenbereich des Kraftfahrzeugs, ist die Sensorfläche dabei erfindungsgemäß vollständig von einem Isolierkörper umgeben. Dabei werden auch die Randbereiche der Löcher von dem Isolierkörper eingefasst, so dass kein Bereich der Sensorfläche in Kontakt zu der Umwelt steht.

Vorteilhafterweise ist die Geometrie aller Löcher der Sensorfläche gleich. Die Mittelpunkte der Löcher liegen zweckmäßigerweise auf einer Geraden, die sich in Längsrichtung des Sensorelements erstreckt.

In einer geeigneten Ausführungsform der Erfindung ist das Sensorelement biegsam. Die Sensorfläche besteht vorteilhafterweise aus Kupfer und wird zweckmäßigerweise aus einer Flachbandleitung gebildet. Der Isolierkörper besteht beispielsweise im Wesentlichen aus PVC. Der Isolierkörper ist bevorzugt quaderförmig und weist insbesondere eine Länge zwischen 10cm und 200cm, eine Breite zwischen 0,1cm und 10cm und eine Dicke zwischen 0,1mm und 20mm auf.

Der Isolierkörper kann im unmontierten Zustand die Löcher der Sensorfläche vollständig ausfüllen. Beispielsweise werden in diesem Fall bei der Montage die zur Befestigung dienenden Schrauben direkt in den Isolierkörper eingeschraubt. In einer bevorzugten Ausführungsform ist jedoch in den Isolierkörper bereits eine Anzahl von Aussparungen, insbesondere zur leichten Montage des Sensorelements an einem Objekt, eingebracht. Unter einer Aussparung wird dabei allgemein eine Durchgangsöffnung innerhalb des Isolierkörpers verstanden. Der Isolierkörper weist vorzugsweise genauso viele Aussparungen auf, wie die Sensorfläche Löcher. Jeweils genau eine der Aussparungen ist also innerhalb eines der Löcher angeordnet, wobei der Rand der Aussparung den Rand des zugehörigen Lochs nicht berührt, so dass das Sensorelement hermetisch abgeschlossen ist. Vorteilhafterweise ist der Abstand zwischen dem Rand der Aussparung und dem Rand des zugehörigen Lochs im Wesentlichen konstant, so dass die Querschnittsfläche der Aussparung die Form des zugehörigen Lochs aufweist, wobei der Flächeninhalt der Querschnittsfläche kleiner ist als die Größe des Lochs. Zweckmäßigerweise ist die Form aller Aussparungen gleich.

An mindestens einem Längsende des Sensorelements befindet sich ein dicht mit der Isolierschicht verbundener Abschluss. Der Abschluss besteht vorzugsweise aus einem Schmelzklebestoff auf Basis von Polyamid, insbesondere aus Macromelt, und ist an das Sensorelement angespritzt oder angegossen. Alternativ kann der Abschluss auf das Ende des Sensorelements aufgesteckt und mit der Isolierschicht dicht verschweißt oder verklebt sein. In mindestens einen der Abschlüsse ist bevorzugt eine Kontaktstelle eingebettet, an der die Sensorfläche mit einer elektrischen Anschlussleitung kontaktiert ist.

Nach dem erfindungsgemäßen Herstellungsverfahren werden zunächst die Löcher in die Sensorfläche eingebracht. Dies kann beispielsweise durch Stanzen erfolgen.

In einem darauffolgenden Arbeitsschritt wird die Sensorfläche von dem Isolierkörper vollständig umhüllt, wobei die Löcher der Sensorfläche zunächst von dem Isolierkörper ausgefüllt werden. Die Aufbringung des Isolierkörpers kann beispielsweise mittels Umspritzen der Sensorfläche erfolgen. Denkbar wäre auch die Einlaminierung der Sensorfläche zwischen zweier zur Bildung des Isolierkörpers miteinander verklebten oder verschweißten Kunststoffstreifen, die eine größere Ausdehnung als die Sensorfläche aufweisen, und vollständig über die Ränder der Sensorfläche hinausragen.

In vorteilhafter Ausführung des Verfahrens wird in einem weiteren Arbeitsschritt jeweils im Bereich eines jeden der Löcher genau eine Aussparung in den Isolierkörper derart eingebracht, vorzugsweise gestanzt, dass der Rand einer jeden Aussparung den Rand des zugehörigen Loches nicht berührt und das Sensorelement somit hermetisch abgeschlossen ist.

Nachfolgend wird ein Ausführungsbeispiel anhand einer Zeichnung näher erläutert. Darin zeigen:
- Fig. 1: schematisch einen kapazitiven Abstandssensor mit einem langgestreckten Sensorelement, und
- Fig. 2: ausschnittsweise perspektivisch das Sensorelement.

Einander entsprechende Teile sind in allen Figuren mit den gleichen Bezugszeichen versehen.

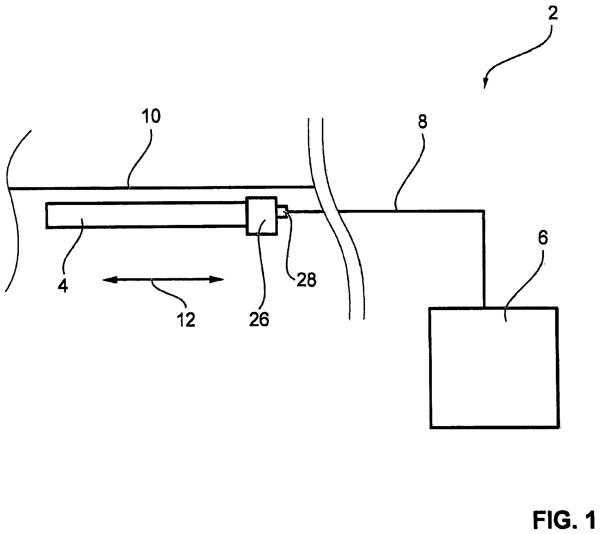

In Fig. 1 ist schematisch ein kapazitiver Abstandssensor 2 dargestellt. Der Abstandssensor 2 umfasst ein langgestrecktes, flexibles Sensorelement 4, eine Elektronik 6 sowie eine das Sensorelement 4 mit der Elektronik 6 elektrisch verbindende Anschlussleitung 8. Beispielsweise befindet sich der Abstandssensor 2 innerhalb eines Kraftfahrzeugs. Insbesondere wird im Rahmen einer schlüssellosen Startautomatik (Keyless-Go) mittels des Abstandssensors 2 eine Annäherung einer Person an das geparkte Kraftfahrzeug überwacht. In einem zweckmäßigen Anwendungsfall ist das Sensorelement 4 im Heckbereich des Kraftfahrzeugs, beispielsweise an dem hinteren Stoßfängers 10 angebracht. Geeigneterweise verläuft die Längsrichtung 12 des Sensorelements 4 parallel zu den Radachsen des Fahrzeugs.

Die Elektronik 6 versorgt das Sensorelement 4 mit Strom und wertet die Messdaten des Sensorelements 4 aus. Insbesondere kann aufgrund eines von dem Abstandssensor 2 emittierten Signals die Heckklappe des Kraftfahrzeugs geöffnet werden, so dass die sich nähernde Person keine manuelle Tätigkeit zum Öffnen der Klappe vornehmen muss.

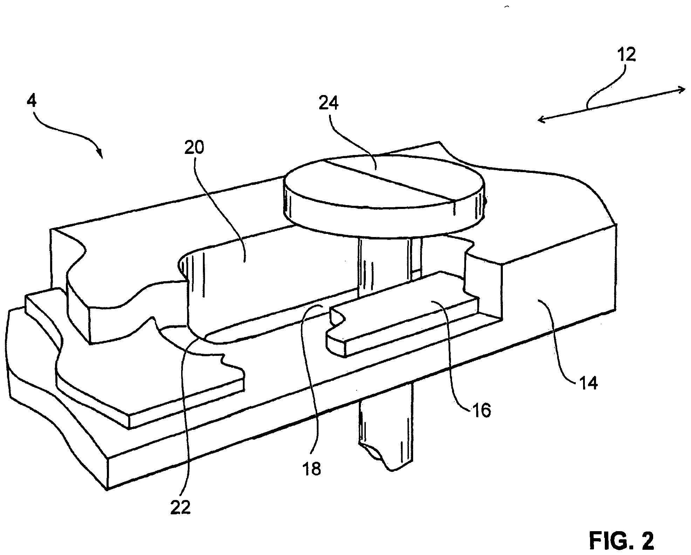

In Fig. 2 ist das Sensorelement 4 näher dargestellt. Wie aus der Darstellung ersichtlich, umfasst das Sensorelement 4 einen Isolierkörper 14, in den eine Sensorfläche 16 derart eingebettet ist, dass die Sensorfläche 16 vollständig von dem Isolierkörper 14 umhüllt ist. Der Isolierkörper 14 liegt formschlüssig an der Sensorfläche 16 an, beispielsweise zur Vermeidung einer Verschiebung der Sensorfläche 16 bezüglich des Isolierkörpers 14 und/oder zur Erhöhung der Stabilität des Sensorelements 4. Die beispielsweise aus Kupfer bestehende Sensorfläche 16 ist langgestreckt und flach und weist insbesondere eine Streifenform auf. In die Sensorfläche 16 ist eine Anzahl Löcher 18 eingestanzt. Die Löcher 18 weisen die Form eines Langlochs aus, wobei sich die langen Achsen der Langlöcher entlang der Längsrichtung 12 der Sensorfläche 16 erstrecken. Die Mittelpunkte der Löcher 18 befindet sich auf einer Geraden, die sich in Längsrichtung 12 der Sensorfläche 16 erstreckt und sich mittig auf der Sensorfläche 16 befindet.

Der insbesondere aus PVC bestehende Isolierkörper 14 hat die Form eines flachen Quaders, wobei zwei Oberflächen parallel zu der Sensorfläche 16 sind. Der Isolierkörper 14 weist beispielsweise eine Länge von etwa 63cm, eine Breite von etwa 3cm und eine Dicke von etwa 0,2cm auf. Innerhalb jedes Loches 18 der Sensorfläche 16 verläuft eine Aussparung 20 des Isolierkörpers 14. Die Form der Aussparungen 20 entspricht im Wesentlichen der der Löcher 18. Der Randbereich 22 der Löcher 18 ist von dem Isolierkörper 14 ausgefüllt. Innerhalb der Aussparungen 20 kann sich in montiertem Zustand des Abstandssensors 2 beispielsweise jeweils eine Schraube 24 befinden, mittels derer das Sensorelement 4 an einem Objekt befestigt ist.

An einem Ende des Sensorelements 4 befindet sich ein Abschluss 26 (Fig.1). Der Körper des Abschlusses 26 besteht aus Macromelt und ist an das Sensorelement 4 angegossen. In den Abschluss 26 ist eine Anschlussstelle 28 eingebettet, an der das Sensorelement 4 mit der Anschlussleitung 8 elektrisch kontaktiert ist.

Im Verlauf der Herstellung des Sensorelements 4 werden in die Sensorfläche 16 zunächst die Löcher 18 gestanzt. In einem darauffolgenden Arbeitsschritt wird die Sensorfläche 16 vollständig von dem Isolierkörper 14 ummantelt. Nachfolgend werden in den Isolierkörper 14 die Aussparungen 20 eingebracht.

### Bezugszeichenliste

- 2: Abstandssensor
- 4: Sensorelement
- 6: Elektronik
- 8: Anschlussleitung
- 10: hinterer Stoßfänger
- 12: Längsrichtung
- 14: Isolierkörper
- 16: Sensorfläche
- 18: Loch
- 20: Aussparung
- 22: Randbereich
- 24: Schraube
- 26: Abschluss
- 28: Anschlussstelle

## Patentansprüche

1. Kapazitiver Abstandssensor (2) mit einem Sensorelement (4), das eine elektrisch leitende, langgestreckte, flache Sensorfläche (16) umfasst, wobei in die Sensorfläche (16) eine Anzahl von Löchern (18) zur Befestigung des Sensorelements (4) an einem Objekt eingebracht ist,
**dadurch gekennzeichnet,**
**dass** die Sensorfläche (16) von einem elektrisch nichtleitenden Isolierkörper (14) vollständig umschlossen ist, so dass der Isolierkörper (14) die Randbereiche (22) der Löcher (18) vollständig überdeckt.

2. Kapazitiver Abstandssensor (2) nach Anspruch 1,
**dadurch gekennzeichnet,**
**dass** das Sensorelement (4) biegsam ist.

3. Kapazitiver Abstandssensor (2) nach Anspruch 1 oder 2,
**dadurch gekennzeichnet,**
**dass** die Sensorfläche (16) aus Kupfer besteht.

4. Kapazitiver Abstandssensor (2) nach einem der Ansprüche 1 bis 3,
**dadurch gekennzeichnet,**
**dass** der Isolierkörper (14) im Wesentlichen aus PVC besteht.

5. Kapazitiver Abstandssensor (2) nach einem der Ansprüche 1 bis 4,
**dadurch gekennzeichnet,**
**dass** der Isolierkörper (14) eine zu der Anzahl der Löcher (18) korrespondierende Anzahl von Aussparungen (20) enthält, wobei jede Aussparung (20) innerhalb eines der Löcher (18) verläuft.

6. Kapazitiver Abstandssensor (2) nach Anspruch 5,
**dadurch gekennzeichnet,**
**dass** die Querschnittsfläche einer jeden Aussparungen (20) im Wesentlichen die gleiche Form wie die des jeweiligen korrespondierenden Lochs (18), durch das die Aussparung (20) verläuft, aufweist.

7. Verfahren zur Herstellung eines Sensorelements (4),
**dadurch gekennzeichnet,**
**dass** in eine flache, langgestreckte, aus einem elektrisch leitenden Material bestehende Sensorfläche (16) eine Anzahl Löcher (18) zur Befestigung des Sensorelements (4) an einem Objekt eingebracht wird, und wobei in einem darauffolgenden Arbeitsschritt die Sensorfläche (16) von einem aus einem elektrisch nichtleitenden Material bestehenden Isolierkörper (14) vollständig umhüllt wird, der auch die Löcher (18) der Sensorfläche (16) vollständig ausfüllt.

8. Verfahren zur Herstellung eines Sensorelements (4) nach Anspruch 7,
**dadurch gekennzeichnet,**
**dass** in einem darauffolgenden Arbeitsschritt in den Isolierkörper (14) eine zu der Anzahl der Löcher (18) korrespondierende Anzahl von Aussparungen (20) so eingebracht wird, dass jede Aussparung (20) innerhalb eines der Löcher (18) verläuft und der Rand der Aussparung (20) durchwegs einen Abstand zu dem Rand des zugehörigen Lochs (18) aufweist.

## Claims

1. Capacitive distance sensor (2) with a sensor element (4), said sensor element (4) comprising an electrically conductive, elongated, flat sensor surface (16), wherein a plurality of holes (18) is introduced in the sensor surface (16) for fastening the sensor element (4) to an object,
**characterized in**
**that** the sensor surface (16) is completely enclosed by an electrically non-conductive insulating body (14), so that the insulating body (14) completely covers the edge regions (22) of the holes (18).

2. Capacitive distance sensor (2) according to claim 1,
**characterized in**
**that** the sensor element (4) is flexible.

3. Capacitive distance sensor (2) according to claim 1 or 2,
**characterized in**
**that** the sensor surface (16) consists of copper.

4. Capacitive distance sensor (2) according to one of claims 1 to 3,
**characterized in**
**that** the insulating body (14) substantially consists of PVC.

5. Capacitive distance sensor (2) according to one of claims 1 to 4,
**characterized in**
**that** the insulating body (14) contains a plurality of cutouts (20) corresponding to the number of holes (18), wherein each cutout (20) extends within one of the holes (18).

6. Capacitive distance sensor (2) according to claim 5,
**characterized in**
**that** the cross-sectional area of each cutout (20) has substantially the same shape as that of the respective corresponding hole (18) through which the cutout (20) extends.

7. Method for manufacturing a sensor element (4),
**characterized in**
**that** a plurality of holes (18) for fastening the sensor element (4) to an object is introduced in a flat, elongate sensor surface (16) consisting of an electrically conductive material, and in which, in a subsequent working step, the sensor surface (16) is completely enclosed by an insulating body (14) consisting of an electrically non-conductive material, which also completely fills the holes (18) of the sensor surface (16).

8. Method for manufacturing a sensor element (4) according to claim 7,
**characterized in**
**that**, in a subsequent working step, a plurality of cutouts (20) corresponding to the number of holes (18) is introduced in the insulating body (14) in such a way that each cutout (20) consistently runs within one of the holes (18) and the edge of the cutout (20) is spaced apart from the edge of the associated hole (18).

## Revendications

1. Capteur de distance capacitif (2) avec un élément de capteur (4), ledit élément de capteur (4) comprenant une surface de capteur (16) électriquement conductrice, allongée et plane, dans lequel une pluralité de trous (18) est réalisée dans la surface de capteur (16) pour fixer l'élément de capteur (4) à un objet
**caractérisé en ce**
**que** la surface du capteur (16) est entièrement entourée d'un corps isolant (14) électriquement non conducteur, de sorte que le corps isolant (14) recouvre entièrement les zones de bord (22) des trous (18).

2. Capteur de distance capacitif (2) selon la revendication 1,
**caractérisé en ce**
**que** l'élément capteur (4) est flexible.

3. Capteur de distance capacitif (2) selon la revendication 1 ou 2,
**caractérisé en ce**
**que** la surface du capteur (16) est constituée de cuivre.

4. Capteur de distance capacitif (2) selon l'une des revendications 1 à 3,
**caractérisé en ce**
**que** le corps isolant (14) est essentiellement constitué de PVC.

5. Capteur de distance capacitif (2) selon l'une des revendications 1 à 4,
**caractérisé en ce**
**que** le corps isolant (14) comporte une pluralité d'évidements (20) correspondante au nombre de trous (18), dans lequel chaque évidement (20) s'étend à l'intérieur d'un des trous (18).

6. Capteur de distance capacitif (2) selon la revendication 5,
**caractérisé en ce**
**que** la section transversale de chaque évidement (20) a sensiblement la même forme que celle du trou (18) correspondant respectif, à travers lequel s'étend l'évidement (20).

7. Procédé de fabrication d'un élément de capteur (4),
**caractérisé en ce**
**qu'**une pluralité de trous (18) pour la fixation de l'élément de capteur (4) à un objet est réalisée dans une surface de capteur (16) plane et allongée, constituée d'un matériau électriquement conducteur, et dans lequel, dans une étape de travail ultérieure, la surface de capteur (16) est complètement entourée par un corps isolant (14) constitué d'un matériau électriquement non conducteur, qui remplit également complètement les trous (18) de la surface de capteur (16).

8. Procédé de fabrication d'un élément de capteur (4) selon la revendication 7,
**caractérisé en ce**
**que**, dans une étape de travail ultérieure, une pluralité d'évidements (20) correspondant au nombre de trous (18) est réalisée dans le corps isolant (14), de telle sorte que chaque évidement (20) s'étende à l'intérieur de l'un des trous (18) et que le bord de l'évidement (20) est espacé du bord du trou (18) associé.
